# EUROPEAN PATENT APPLICATION

(11) **EP 4 577 017 A1**
(43) Date of publication of application: **25.06.2025**
(21) Application number: 23218727.8
(22) Date of filing: 20.12.2023
(51) Int. Cl.: H10K 50/854, G02F 1/1335

(54) **OPTICAL OUTCOUPLING MATERIAL, ORGANIC LIGHT EMITTING DEVICE, DISPLAY DEVICE, PROCESS FOR PREPARING THE ORGANIC LIGHT EMITTING DEVICE AND COMPOUND**

(71) Applicant: Novaled GmbH, 01099 Dresden (DE)
(72) Inventor: STENNETT, Thomas, 01099 Dresden (DE); GANIER, Jerome, 01099 Dresden (DE); MALSCH, Franka, 01099 Dresden (DE)
(74) Representative: Bittner, Thomas L.

(57) **Abstract**

The present invention relates to an optical outcoupling material. The present invention relates further to an organic light emitting device and to a display device comprising the organic light emitting device. The present invention relates further to a process for preparing the organic light emitting device. Furthermore, the invention is related to a compound which can be used in an organic light emitting device.

## Description

The present invention relates to an optical outcoupling material. The present invention relates further to an organic light emitting device and to a display device comprising the organic light emitting device. The present invention relates further to a process for preparing the organic light emitting device. Furthermore, the invention is related to a compound which can be used in an organic light emitting device.

### BACKGROUND OF THE INVENTION

Organic semiconducting devices, such as organic light-emitting diodes OLEDs, which are self-emitting devices, have a wide viewing angle, excellent contrast, quick response, high brightness, excellent operating voltage characteristics, and color reproduction. A typical OLED comprises an anode, a hole transport layer HTL, an emission layer EML, an electron transport layer ETL, and a cathode, which are sequentially stacked on a substrate. In this regard, the HTL, the EML, and the ETL are thin films formed from organic compounds.

When a voltage is applied to the anode and the cathode, holes injected from the anode move to the EML, via the HTL, and electrons injected from the cathode move to the EML, via the ETL. The holes and electrons recombine in the EML to generate excitons. When the excitons drop from an excited state to a ground state, light is emitted. The injection and flow of holes and electrons should be balanced, so that an OLED having the above-described structure has excellent efficiency and/or a long lifetime.

Performance of an organic light emitting diode may be affected by characteristics of the organic semiconductor layer, and among them, may be affected by characteristics of an organic material of the organic semiconductor layer.

Particularly, development of an organic semiconductor layer being capable of increasing electron mobility and simultaneously increasing electrochemical stability is needed so that the organic semiconducting device, such as an organic light emitting diode, may be applied to a large-size flat panel display.

Further, development of an organic semiconductor layer being capable to have an extended life span at higher current density and thereby at higher brightness is needed. In particular, the development of an organic semiconductor material or semiconductor layer is needed with respect to lowering the operating voltage, which is important for reducing power consumption and increasing battery life, for example of a mobile display device.

It is, therefore, the object of the present invention to provide optical outcoupling materials and compounds for preparing organic light emitting diodes and display devices overcoming drawbacks of the prior art, in particular with improved performance, especially with higher quantum efficiency.

### DISCLOSURE

This object is achieved by an outcoupling material comprising a compound of the formula (I)

G¹-L-G² (I)

wherein
- G¹ is selected from (Ia) to (Id) 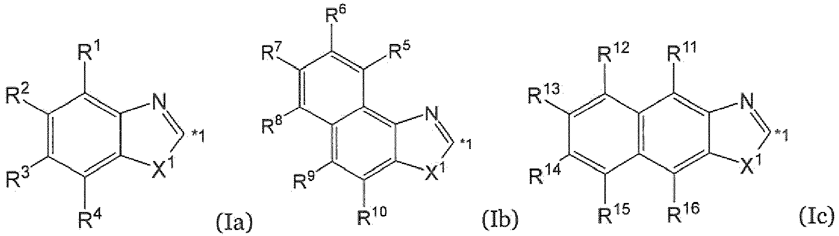 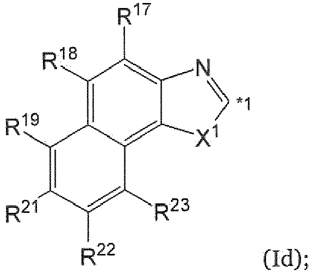
- X¹ is O or S;
- R¹ to R²³ are independently selected from the group consisting of H, D and C₁ to C₈ alkyl;
- G¹ is bonded at *1 to L;
- G² is selected from (Ia') to (Id') 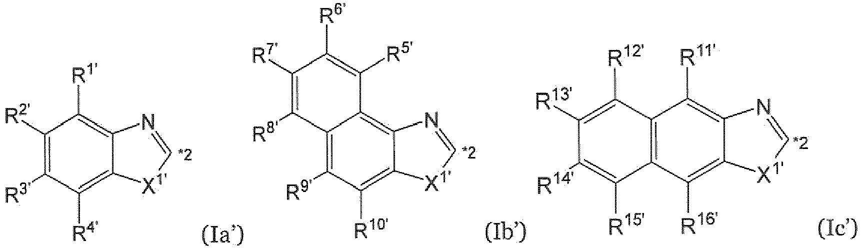 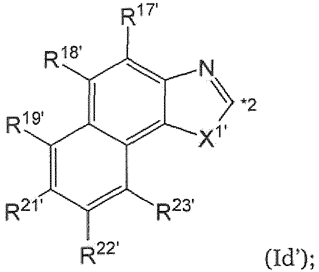
- X^{1'} is O or S;
- R^{1'} to R^{23'} are independently selected from the group consisting of H, D and C₁ to C₈ alkyl;
- G² is bonded at *2 to L;
- L is selected from the group consisting of substituted or unsubstituted C₁ to C₃₀ hydrocarbyl comprising at least two sp³-carbon atoms; and substituted or unsubstituted C₁ to C₃₀ heterohydrocarbyl comprising at least two sp³-carbon atoms;
- L is bonded to G¹ and G² via different sp³-carbon atoms, respectively; and
- in case that L is substituted, the one or more substituent(s) are independently selected from the group consisting of D, C₁ to C₈ alkyl, C₁ to C₈ alkoxy, C₃ to C₉ silyl.

The object is further achieved by an organic light emitting device comprising a light scattering layer comprising the optical outcoupling material according to the invention.

The object is further achieved by a display device comprising the organic light emitting device according to the present invention.

The object is further achieved by a process for preparing the organic light emitting device according to the present invention comprising a step of depositing the optical outcoupling material according to the present invention to form the light scattering layer.

Finally, the object is achieved by a compound having the formula (II)

G¹-L-G² (II)

wherein
- G¹ is selected from (Ib) to (Id) 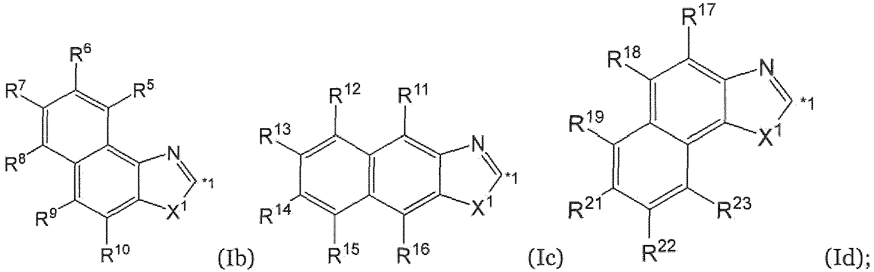
- X₁ is O or S;
- R⁵ to R²³ are independently selected from the group consisting of H, D and C₁ to C₈ alkyl;
- G¹ is bonded at *1 to L;
- G² is selected from (Ib') to (Id') 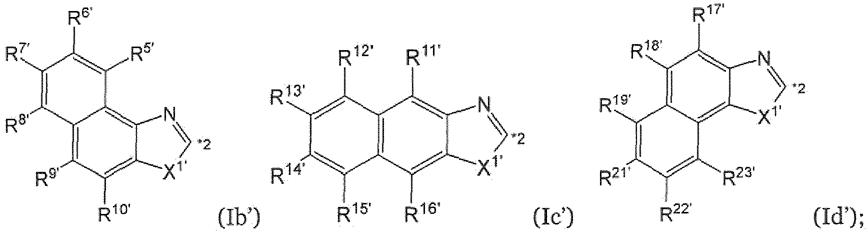
- X^{1'} is O or S;
- R^{5'} to R^{23'} are independently selected from the group consisting of H, D and C₁ to C₈ alkyl;
- G² is bonded at *2 to L;
- L has the formula (Ie) 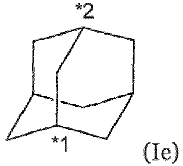 wherein Ie is bonded to G¹ at *1; and Ie is bonded to G² at *2;
- L may be substituted or unsubstituted; and
- in case that L is substituted, the one or more substituent(s) are independently selected from the group consisting of D, C₁ to C₈ alkyl, C₁ to C₈ alkoxy, C_{3 to} C₉ silyl.

### Optical outcoupling material

The optical outcoupling material according to the invention comprises, essentially comprises or consists of a compound of the formula (I)

G¹-L-G² (I).

Formation of an optical outcoupling material comprising or consisting of the compound of formula (I) requires appropriate arrangement of the compound of formula (I) such as forming a layer of the compound of formula (I) on a solid substrate, especially depositing the compound of formula (I) in the preparation process of an organic light emitting device on one or more of the layers of the organic light emitting device in the form of a layer.

In formula (I), G¹ is selected from (Ia) to (Id)

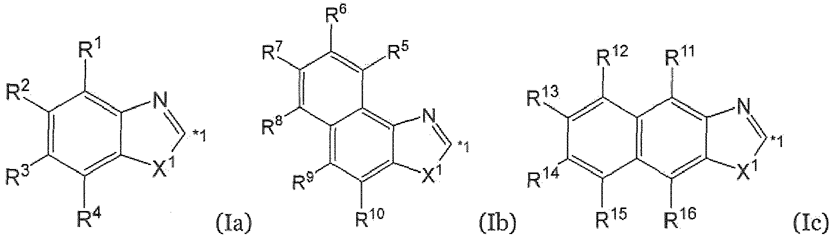

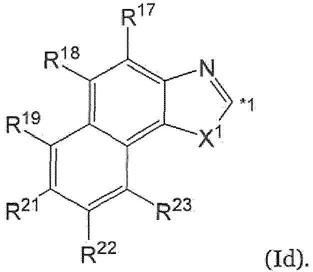

G¹ may be selected from (Ia) and (lb).

X¹ is O or S. X¹ may be O.

R¹ to R²³ are independently selected from the group consisting of H, D and C₁ to C₈ alkyl. R¹ to R²³ may be independently selected from the group consisting of H, D and C₁ to C₆ alkyl. R¹ to R²³ may be independently selected from the group consisting of H, D and C₁ to C₄ alkyl. R¹ to R²³ may be independently selected from the group consisting of H, D and C₁ to C₃ alkyl. R¹ to R²³ may be independently selected from the group consisting of H, D and C₁ to C₂ alkyl. R¹ to R²³ may be independently selected from the group consisting of H, D and methyl. R¹ to R²³ may be independently selected from the group consisting of H and D.

G¹ is bonded at *1 to L. That is, for example, if G¹ is (Ia), the compound of formula (I) has the following structure

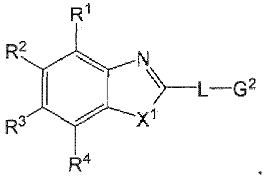

G² is selected from (Ia') to (Id')

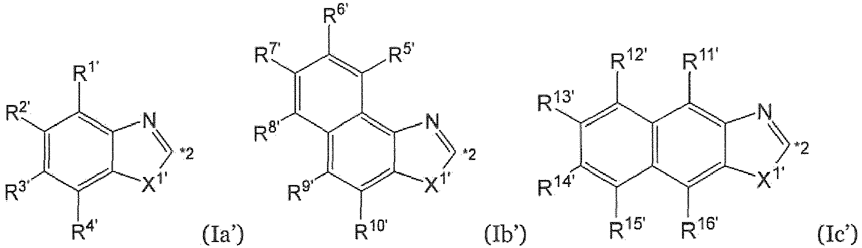

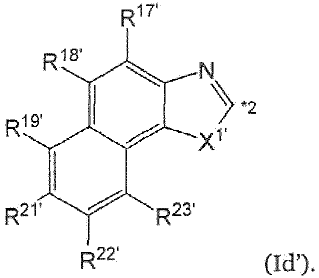

G² may be selected from (Ia') and (lb').

X^{1'} is O or S. X^{1'} may be O.

X¹ and X^{1'} may be both O.

R^{1'} to R^{23'} are independently selected from the group consisting of H, D and C₁ to C₈ alkyl. R^{1'} to R^{23'} may be independently selected from the group consisting of H, D and C₁ to C₆ alkyl. R^{1'} to R^{23'} may be independently selected from the group consisting of H, D and C₁ to C₄ alkyl. R^{1'} to R^{23'} may be independently selected from the group consisting of H, D and C₁ to C₃ alkyl. R^{1'} to R^{23'} may be independently selected from the group consisting of H, D and C₁ to C₂ alkyl. R^{1'} to R^{23'} may be independently selected from the group consisting of H, D and methyl. R^{1'} to R^{23'} may be independently selected from the group consisting of H and D.

G² is bonded at *2 to L. That is, for example, if G² is (Ia'), the compound of formula (I) has the following structure

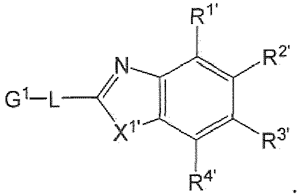

L is selected from the group consisting of substituted or unsubstituted C₁ to C₃₀ hydrocarbyl comprising at least two sp³-carbon atoms; and substituted or unsubstituted C₁ to C₃₀ heterohydrocarbyl comprising at least two sp³-carbon atoms.

In terms of the present disclosure, hydrocarbyl is an univalent group formed by removing a hydrogen atom from a hydrocarbon, e.g. ethyl, phenyl etc. A hydrocarbylene is a two- or more-valent group formed by removing two or more hydrogen atoms from a hydrocarbon, e.g. ethylene, phenylene etc.

In terms of the present disclosure, heterohydrocarbyl is a hydrocarbyl in which (formally) one or more C-atoms is/are replaced by heteroatom(s), such as N, O, S, P etc.

It is provided that the hydrocarbyl/heterohydrocarbyl comprises at least two sp³-carbon atoms.

An sp³-carbon atom is a sp³ hybridized carbon atom, that is, a tetravalent carbon atom forming single covalent bonds (sigma bonds) with atoms of other elements, especially p-block elements, such as H, O, C, N, halogen etc. For example, in an alkane, cycloalkane, polycyclic alkane etc., all carbon atoms are sp³-hybridized.

L may be selected from the group consisting of substituted or unsubstituted C₂ to C₂₄ hydrocarbyl comprising at least two sp³-carbon atoms; and substituted or unsubstituted C₂ to C₂₄ heterohydrocarbyl comprising at least two sp³-carbon atoms. L may be selected from the group consisting of substituted or unsubstituted C₃ to C₂₀ hydrocarbyl comprising at least two sp³-carbon atoms; and substituted or unsubstituted C₃ to C₂₀ heterohydrocarbyl comprising at least two sp³-carbon atoms. L may be selected from the group consisting of substituted or unsubstituted C₄ to C₁₈ hydrocarbyl comprising at least two sp³-carbon atoms; and substituted or unsubstituted C₄ to C₁₈ heterohydrocarbyl comprising at least two sp³-carbon atoms. L may be selected from the group consisting of substituted or unsubstituted C₅ to C₁₆ hydrocarbyl comprising at least two sp³-carbon atoms; and substituted or unsubstituted C₅ to C₁₆ heterohydrocarbyl comprising at least two sp³-carbon atoms. L may be selected from the group consisting of substituted or unsubstituted C₆ to C₁₅ hydrocarbyl comprising at least two sp³-carbon atoms; and substituted or unsubstituted C₆ to C₁₅ heterohydrocarbyl comprising at least two sp³-carbon atoms. L may be selected from the group consisting of substituted or unsubstituted C₇ to C₁₃ hydrocarbyl comprising at least two sp³-carbon atoms; and substituted or unsubstituted C₇ to C₁₃ heterohydrocarbyl comprising at least two sp³-carbon atoms. L may be selected from the group consisting of substituted or unsubstituted C₈ to C₁₂ hydrocarbyl comprising at least two sp³-carbon atoms; and substituted or unsubstituted C₈ to C₁₂ heterohydrocarbyl comprising at least two sp³-carbon atoms. L may be selected from the group consisting of substituted or unsubstituted C₉ to C₁₁ hydrocarbyl comprising at least two sp³-carbon atoms; and substituted or unsubstituted C₉ to C₁₁ heterohydrocarbyl comprising at least two sp³-carbon atoms. L may be selected from the group consisting of substituted or unsubstituted C₁₀ hydrocarbyl comprising at least two sp³-carbon atoms; and substituted or unsubstituted C₁₀ heterohydrocarbyl comprising at least two sp³-carbon atoms.

It may be provided that L does not comprise an aromatic ring. It may be provided that L is saturated.

L may be selected from the group consisting of substituted or unsubstituted C₂ to C₂₄ hydrocarbyl comprising at least two sp³-carbon atoms. L may be selected from the group consisting of substituted or unsubstituted C₃ to C₂₀ hydrocarbyl comprising at least two sp³-carbon atoms. L may be selected from the group consisting of substituted or unsubstituted C₄ to C₁₈ hydrocarbyl comprising at least two sp³-carbon atoms. L may be selected from the group consisting of substituted or unsubstituted C₅ to C₁₆ hydrocarbyl comprising at least two sp³-carbon atoms. L may be selected from the group consisting of substituted or unsubstituted C₆ to C₁₅ hydrocarbyl comprising at least two sp³-carbon atoms. L may be selected from the group consisting of substituted or unsubstituted C₇ to C₁₃ hydrocarbyl comprising at least two sp³-carbon atoms. L may be selected from the group consisting of substituted or unsubstituted C₈ to C₁₂ hydrocarbyl comprising at least two sp³-carbon atoms. L may be selected from the group consisting of substituted or unsubstituted C₉ to C₁₁ hydrocarbyl comprising at least two sp³-carbon atoms. L may be selected from the group consisting of substituted or unsubstituted C₁₀ hydrocarbyl comprising at least two sp³-carbon atoms.

L may be selected from the group consisting of substituted or unsubstituted C₂ to C₂₄ alkylene. L may be selected from the group consisting of substituted or unsubstituted C₃ to C₂₀ alkylene. L may be selected from the group consisting of substituted or unsubstituted C₄ to C₁₈ alkylene. L may be selected from the group consisting of substituted or unsubstituted C₅ to C₁₆ alkylene. L may be selected from the group consisting of substituted or unsubstituted C₆ to C₁₅ alkylene. L may be selected from the group consisting of substituted or unsubstituted C₇ to C₁₃ alkylene. L may be selected from the group consisting of substituted or unsubstituted C₈ to C₁₂ alkylene. L may be selected from the group consisting of substituted or unsubstituted C₉ to C₁₁ alkylene. L may be selected from the group consisting of substituted or unsubstituted C₁₀ alkylene. In this regard, the term alkylene encompasses linear alkylene, branched alkylene, cyclic alkylene, polycyclic alkylene ets.

L may be selected from the group consisting of substituted or unsubstituted C₂ to C₂₄ polycyclic alkylene. L may be selected from the group consisting of substituted or unsubstituted C₃ to C₂₀ polycyclic alkylene. L may be selected from the group consisting of substituted or unsubstituted C₄ to C₁₈ polycyclic alkylene. L may be selected from the group consisting of substituted or unsubstituted C₅ to C₁₆ polycyclic alkylene. L may be selected from the group consisting of substituted or unsubstituted C₆ to C₁₅ polycyclic alkylene. L may be selected from the group consisting of substituted or unsubstituted C₇ to C₁₃ polycyclic alkylene. L may be selected from the group consisting of substituted or unsubstituted C₈ to C₁₂ polycyclic alkylene. A polycyclic alkane is and alkane featuring several closed rings of carbon atoms.

L may be selected from the group consisting of substituted or unsubstituted C₂ to C₂₄ bicyclic alkylene. L may be selected from the group consisting of substituted or unsubstituted C₃ to C₂₀ bicyclic alkylene. L may be selected from the group consisting of substituted or unsubstituted C₄ to C₁₈ bicyclic alkylene. L may be selected from the group consisting of substituted or unsubstituted C₅ to C₁₆ bicyclic alkylene. L may be selected from the group consisting of substituted or unsubstituted C₆ to C₁₅ bicyclic alkylene. L may be selected from the group consisting of substituted or unsubstituted C₇ to C₁₃ bicyclic alkylene. L may be selected from the group consisting of substituted or unsubstituted C₈ to C₁₂ bicyclic alkylene. Bicyclic molecule (from bi 'two', and cycle 'ring') is a molecule that features two joined rings, especially bicyclic spiro alkanes, bicyclic fused/condensed alkanes and bridged bicyclic alkanes.

L may comprise a moiety having the formula (Ie')

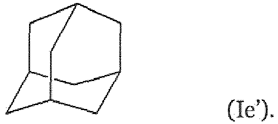

L may have the formula (Ie) 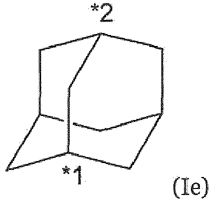 wherein (Ie) is bonded to G¹ at *1; and Ie is bonded to G² at *2. That is, if Lis (Ie), the compound of formula (I) has the following structure

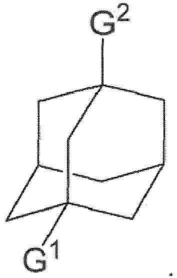

In case that L is substituted, the one or more substituent(s) are independently selected from the group consisting of D, C₁ to C₈ alkyl, C₁ to C₈ alkoxy, C_{3 to} C₉ silyl. In case that L is substituted, the one or more substituent(s) may be independently selected from the group consisting of D, C₁ to C₈ alkyl. In case that L is substituted, the one or more substituent(s) may be independently selected from the group consisting of D, C₁ to C₄ alkyl. In case that L is substituted, the one or more substituent(s) may be D.

G¹ and G² may be selected the same. In this regard, "selected the same" means that the same group/atom is used in the respective positions. For example, G¹ and G² are selected the same if R¹ is Ia and R^{1'} is Ia' wherein it may be preferred that both Ia and la' have the same substitution pattern (R¹ = R^{1'}, R² = R^{2'}, ...).

It may be provided that R¹ and R¹' are selected the same; and R² and R²' are selected the same; and R³ and R³' are selected the same; and R⁴ and R⁴' are selected the same; and R⁵ and R⁵' are selected the same; and R⁶ and R⁶' are selected the same; and R⁷ and R⁷' are selected the same; and R⁸ and R⁸' are selected the same; and R⁹ and R⁹' are selected the same; and R¹⁰ and R¹⁰' are selected the same; and R¹¹ and R¹¹' are selected the same; and R¹² and R¹²' are selected the same; and R¹³ and R¹³' are selected the same; and R¹⁴ and R¹⁴' are selected the same; and R¹⁵ and R¹⁵' are selected the same; and R¹⁶ and R¹⁶' are selected the same; and R¹⁷ and R¹⁷' are selected the same; and R¹⁸ and R¹⁸' are selected the same; and R¹⁹ and R¹⁹' are selected the same; and R²⁰ and R²⁰' are selected the same; and R²¹ and R²¹' are selected the same; and R²² and R²²' are selected the same; and R²³ and R²³' are selected the same. In this regard, "selected the same" means that the same group/atom is used in the respective positions. For example, R¹ and R¹' are selected the same if R¹ is methyl and R¹' is methyl.

It may be provided that G¹ and G² are selected the same; G¹ is selected from Ia and Ib; and G² is selected from Ia' and Ib'.

It may be provided that
- G¹ is selected from Ia and Ib; and G² is selected from Ia' and Ib';
- in Ia and Ia', R² and R²' are independently selected from C₁ to C₄ alkyl; and
- in Ia and Ia', R¹, R³ and R⁴, and R¹', R³' R⁴' are independently H or D.

It may be provided that
- G¹ and G² are selected the same;
- G¹ is selected from Ia and Ib; and G² is selected from Ia' and Ib';
- in Ia and Ia', R² and R²' are independently selected from C₁ to C₄ alkyl; and
- in Ia and Ia', R¹, R³ and R⁴, and R¹', R³' R⁴' are independently H or D.

It may be provided that
- G¹ and G² are selected the same;
- G¹ is selected from Ia and Ib; and G² is selected from Ia' and Ib';
- in Ia and Ia', R¹ to R⁴, and R^{1'} to R^{4'} are independently H or D.

The compound of the formula (I) may have the structure E1 or E2

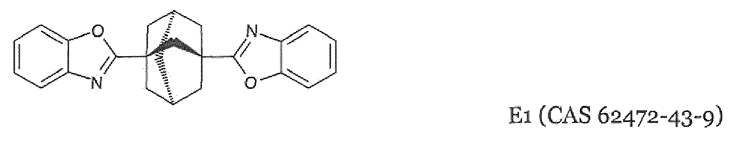

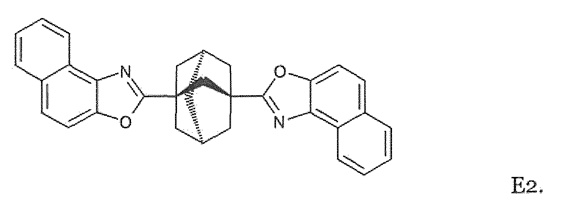

### Organic light emitting device

According to a further aspect, the present invention relates to an organic light emitting device comprising a light scattering layer, wherein the light scattering layer comprises the optical outcoupling material according to the present invention.

The organic light emitting device according to the present invention may comprise a substrate, a bottom-electrode, a top-electrode, an electronically active region and the light-scattering layer, wherein the electronically active region is arranged between and in direct contact with the bottom-electrode and the top-electrode; the bottom electrode is closer to the substrate than the top-electrode; and the light-scattering layer is arranged outside the electronically active region and is arranged on the top-electrode.

The organic light emitting device according to the present invention comprises a light scattering layer. The light scattering layer comprises, essentially comprises, or consists of the optical outcoupling material, especially the compound of formula (I), as defined above.

The organic light emitting device may be an organic light emitting diode.

The organic light emitting device may be a blue organic light emitting device or a green organic light emitting device or a white organic light emitting device.

The organic light emitting device comprises a substrate, a bottom-electrode, a top-electrode, an electronically active region and the light-scattering layer as defined above.

The bottom electrode is closer to the substrate than the top-electrode.

The top electrode may be a cathode, and the bottom-electrode may be an anode.

The electronically active region is arranged between and in direct contact with the bottom-electrode and the top-electrode. The electronically active region may comprise a layer stack. The electronically active region may consist of a layer stack. A layer stack in terms of the present disclosure refers to a stack of separate layers subsequentially deposited on each other.

The organic light emitting diode in accordance with the invention may comprise the following layers, wherein layers besides the substrate, the bottom-electrode, the top-electrode, and the light-scattering layer, may be part of the electronically active region, especially of the layer stack.

### Light scattering layer

The light scattering layer may be a homogeneous layer, especially may consist of the optical outcoupling material, especially the compound of formula (I), as defined above. Alternatively, the light scattering layer may comprise two or more sublayers, wherein a first sublayer is arranged in contact with a transparent electrode and a second sublayer is arranged on top of the first sublayer.

If the second sublayer comprises, essentially comprises or consists of the optical outcoupling material according to present invention, the first sublayer may comprise, essentially comprise or consist of another optical outcoupling material. Typical other optical outcoupling materials that may be comprised in the first sublayer are triaryl amine compounds, such as e.g. compounds G3 or G4 in examples below.

The light scattering layer may comprise the optical outcoupling material as defined above in an amount of 50 wt.% or more, 60 wt.% or more, 70 wt.% or more, 80 wt.% or more, 90 wt.% or more, 95 wt.% or more, 98 wt.% or more, or 99 wt.% or more. The light scattering layer may consist of the optical outcoupling material as defined above.

The light-scattering layer may be arranged outside the electronically active region and may be arranged on the top-electrode. The electronically active region arranged between and in direct contact with the bottom-electrode and the top-electrode may be a layer stack as described below in detail, especially may be a layer stack comprising an electron transport layer. The light scattering layer is not an electron transport layer.

The light scattering layer may be in direct contact with the top-electrode.

The light scattering layer arranged outside the electronically active region and arranged on, preferably directly on, the top-electrode, may improve the outcoupling of light.

### Top electrode

The top-electrode may be a cathode.

The top-electrode may be a transparent top-electrode.

The top-electrode may comprise silver. The top-electrode may comprise silver in an amount of 50 vol% or more, 60 vol% or more, 70 vol% or more, 80 vol% or more, or 85 vol% or more, with respect to the total volume of the top electrode. The top-electrode may comprise silver in an amount of 99 vol% or less, 98 vol% or less, 97 vol% or less, 93 vol% or less, or 91 vol% or less, with respect to the total volume of the top electrode. The top-electrode may comprise silver in an amount of 50 vol% or more and 99 vol% or less, 60 vol% or more and 98 vol% or less, 70 vol% or more and 97 vol% or less, 80 vol% or more and 93 vol% or less, or 85 vol% or more and 91 vol% or less, such as about 90 vol%, with respect to the total volume of the top electrode.

The top-electrode may consist of a binary alloy of silver and a further metal, wherein this further metal is more electropositive than silver. The further metal may be selected from the group consisting of alkali metals, alkaline earth metals and transition metals. The further metal may be selected from the group consisting of Li, Mg and Al. The further metal may be Mg.

### Substrate

The substrate may be any substrate that is commonly used in manufacturing of organic electronic devices, such as organic light-emitting diodes. If light is to be emitted through the substrate, the substrate shall be a transparent or semitransparent material, for example a glass substrate or a transparent plastic substrate. If light is to be emitted through the top surface, the substrate may be both a transparent as well as a non-transparent material, for example a glass substrate, a plastic substrate, a metal substrate, or a silicon substrate.

### Anode electrode

Either the top-electrode or the bottom-electrode comprised in the inventive organic semiconducting device, preferably the bottom-electrode, may be an anode electrode. The anode electrode may be formed by depositing or sputtering a material that is used to form the anode electrode. The material used to form the anode electrode may be a high work-function material, so as to facilitate hole injection. The anode material may also be selected from a low work function material (i.e. aluminum). The anode electrode may be a transparent or reflective electrode. Transparent conductive oxides, such as indium tin oxide (ITO), indium zinc oxide (IZO), tin-dioxide (SnO₂), aluminum zinc oxide (AIZO) and zinc oxide (ZnO), may be used to form the anode electrode. The anode electrode may also be formed using metals, typically silver (Ag), gold (Au), or metal alloys.

### Hole injection layer

A hole injection layer (HIL) may be formed on the anode electrode by vacuum deposition, spin coating, printing, casting, slot-die coating, Langmuir-Blodgett (LB) deposition, or the like. When the HIL is formed using vacuum deposition, the deposition conditions may vary according to the compound that is used to form the HIL, and the desired structure and thermal properties of the HIL. In general, however, conditions for vacuum deposition may include a deposition temperature of 100° C to 500° C, a pressure of 10⁻⁸ to 10⁻³ Torr (1 Torr equals 133.322 Pa), and a deposition rate of 0.1 to 10 nm/sec.

When the HIL is formed using spin coating or printing, coating conditions may vary according to the compound that is used to form the HIL, and the desired structure and thermal properties of the HIL. For example, the coating conditions may include a coating speed of about 2000 rpm to about 5000 rpm, and a thermal treatment temperature of about 80° C to about 200° C. Thermal treatment removes a solvent after the coating is performed.

The HIL may be formed of any compound that is commonly used to form a HIL. Examples of compounds that may be used to form the HIL include a phthalocyanine compound, such as copper phthalocyanine (CuPc), 4,4',4"-tris (3-methylphenylphenylamino) triphenylamine (m-MTDATA), TDATA, 2T-NATA, polyaniline/dodecylbenzenesulfonic acid (Pani/DBSA), poly(3,4-ethylenedioxythiophene)/poly(4-styrenesulfonate) (PEDOT/PSS), polyaniline/camphor sulfonic acid (Pani/CSA), and polyaniline)/poly(4-styrenesulfonate (PANI/PSS).

The HIL may comprise or consist of p-type dopant and the p-type dopant may be selected from tetrafluoro-tetracyanoquinonedimethane (F4TCNQ), 2,2'-(perfluoronaphthalen-2,6-diylidene) dimalononitrile or 2,2',2"-(cyclopropane-1,2,3-triylidene)tris(2-(p-cyanotetrafluorophenyl)acetonitrile) but not limited hereto. The HIL may be selected from a hole-transporting matrix compound doped with a p-type dopant. Typical examples of known doped hole transport materials are: copper phthalocyanine (CuPc), which HOMO level is approximately -5.2 eV, doped with tetrafluoro-tetracyanoquinonedimethane (F4TCNQ), which LUMO level is about -5.2 eV; zinc phthalocyanine (ZnPc) (HOMO = -5.2 eV) doped with F4TCNQ; α-NPD (N,N'-Bis(naphthalen-1-yl)-N,N'-bis(phenyl)-benzidine) doped with F4TCNQ. α-NPD doped with 2,2'-(perfluoronaphthalen-2,6-diylidene) dimalononitrile. The p-type dopant concentrations can be selected from 1 to 20 wt.-%, more preferably from 3 wt.-% to 10 wt.-%.

The thickness of the HIL may be in the range from about 1 nm to about 100 nm, and for example, from about 1 nm to about 25 nm. When the thickness of the HIL is within this range, the HIL may have excellent hole injecting characteristics, without a substantial penalty in driving voltage.

### Hole transport layer

A hole transport layer (HTL) may be formed on the HIL by vacuum deposition, spin coating, slot-die coating, printing, casting, Langmuir-Blodgett (LB) deposition, or the like. When the HTL is formed by vacuum deposition or spin coating, the conditions for deposition and coating may be similar to those for the formation of the HIL. However, the conditions for the vacuum or solution deposition may vary, according to the compound that is used to form the HTL.

The HTL may be formed of any compound that is commonly used to form a HTL. Compounds that can be suitably used are disclosed for example in Yasuhiko Shirota and Hiroshi Kageyama, Chem. Rev. 2007, 107, 953-1010 and incorporated by reference. Examples of the compound that may be used to form the HTL are: carbazole derivatives, such as N-phenylcarbazole or polyvinylcarbazole; benzidine derivatives, such as N,N'-bis(3-methylphenyl)-N,N'-diphenyl-[1,1-biphenyl]-4,4'-diamine (TPD), or N,N'-di(naphthalen-1-yl)-N,N'-diphenyl benzidine (alpha-NPD); and triphenylamine-based compound, such as 4,4',4"-tris(N-carbazolyl)triphenylamine (TCTA). Among these compounds, TCTA can transport holes and inhibit excitons from being diffused into the EML.

The thickness of the HTL may be in the range of about 5 nm to about 250 nm, preferably, about 10 nm to about 200 nm, further about 20 nm to about 190 nm, further about 40 nm to about 180 nm, further about 60 nm to about 170 nm, further about 80 nm to about 160 nm, further about 100 nm to about 160 nm, further about 120 nm to about 140 nm. A preferred thickness of the HTL may be 160 nm to 200 nm,

When the thickness of the HTL is within this range, the HTL may have excellent hole transporting characteristics, without a substantial penalty in driving voltage.

### Electron blocking layer

The function of an electron blocking layer (EBL) is to prevent electrons from being transferred from an emission layer to the hole transport layer and thereby confine electrons to the emission layer. Thereby, efficiency, operating voltage and/or lifetime are improved. Typically, the electron blocking layer comprises a triarylamine compound. The triarylamine compound may have a LUMO level closer to vacuum level than the LUMO level of the hole transport layer. The electron blocking layer may have a HOMO level that is further away from vacuum level compared to the HOMO level of the hole transport layer. The thickness of the electron blocking layer may be selected between 2 and 20 nm.

If the electron blocking layer has a high triplet level, it may also be described as triplet control layer.

The function of the triplet control layer is to reduce quenching of triplets if a phosphorescent green or blue emission layer is used. Thereby, higher efficiency of light emission from a phosphorescent emission layer can be achieved. The triplet control layer is selected from triarylamine compounds with a triplet level above the triplet level of the phosphorescent emitter in the adjacent emission layer. Suitable compounds for the triplet control layer, in particular the triarylamine compounds, are described in EP 2 722 908 A1.

### Emission layer (EML)

The emission layer converts an electrical current into photons. The EML may be formed on the HTL or the EBL by vacuum deposition, spin coating, slot-die coating, printing, casting, LB deposition, or the like. When the EML is formed using vacuum deposition or spin coating, the conditions for deposition and coating may be similar to those for the formation of the HIL. However, the conditions for deposition and coating may vary, according to the compound that is used to form the EML.

It may be provided that the emission layer does not comprise the compound according to the present invention.

The respective emission layer (EML) may be formed of a combination of a host and an emitter dopant. Example of the host are Alq₃, 4,4'-N,N'-dicarbazole-biphenyl (CBP), poly(n-vinylcarbazole) (PVK), 9,10-di(naphthalene-2-yl)anthracene (ADN), 4,4',4"-tris(carbazol-9-yl)-triphenylamine(TCTA), 1,3,5-tris(N-phenylbenzimidazole-2-yl)benzene (TPBI), 3-tert-butyl-9,10-di-2-naphthylanthracenee (TBADN), distyrylarylene (DSA), bis(2-(2-hydroxyphenyl)benzo-thiazolate)zinc (Zn(BTZ)2), EML3 below, Compound 1 below, and Compound 2 below. 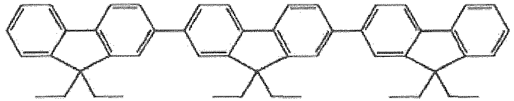 EML3 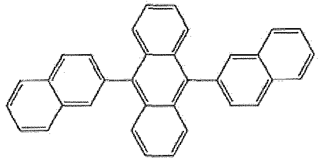 ADN

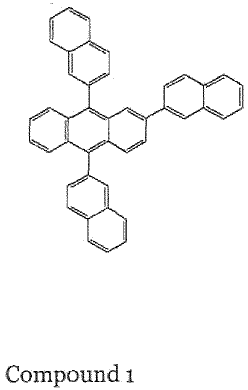

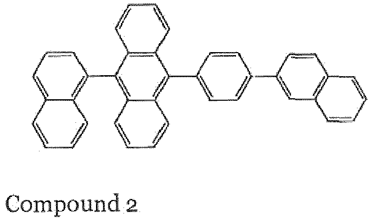

The emitter dopant may be a phosphorescent or fluorescent emitter. Phosphorescent emitters and emitters which emit light via a thermally activated delayed fluorescence (TADF) mechanism may be preferred due to their higher efficiency. The emitter may be a small molecule or a polymer.

Examples of red emitter dopants are PtOEP, Ir(piq)3, and Btp₂lr(acac), but are not limited thereto. These compounds are phosphorescent emitters, however, fluorescent red emitter dopants could also be used.

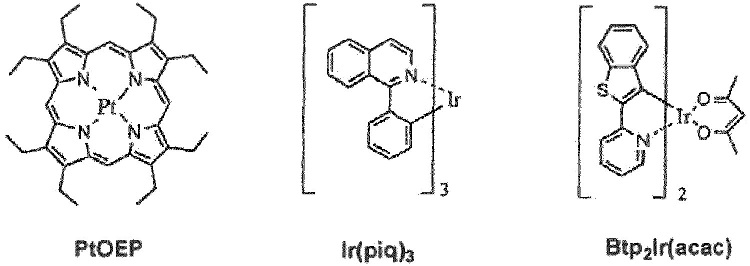

Examples of phosphorescent green emitter dopants are Ir(ppy)₃ (ppy = phenylpyridine), Ir(ppy)₂(acac), Ir(mpyp)₃ are shown below. Compound 3 is an example of a fluorescent green emitter and the structure is shown below.

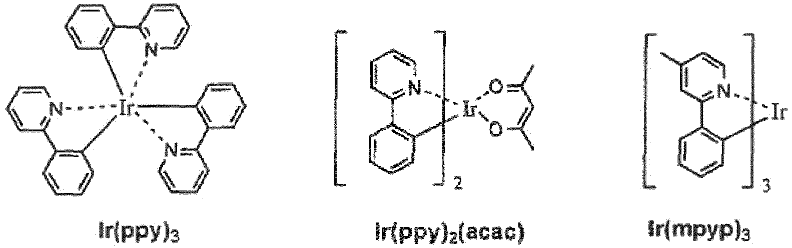

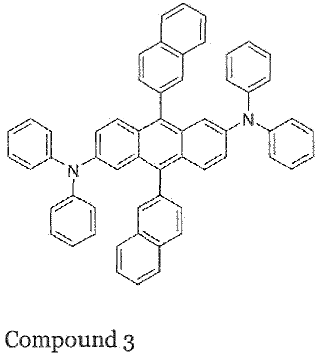

Examples of phosphorescent blue emitter dopants are F2lrpic, (F₂ppy)2Ir(tmd) and Ir(dfppz)₃, ter-fluorene, the structures are shown below. 4.4'-bis(4-diphenyl amiostyryl)biphenyl (DPAVBi), 2,5,8,11-tetra-tert-butyl perylene (TBPe), and Compound 4 below are examples of fluorescent blue emitter dopants.

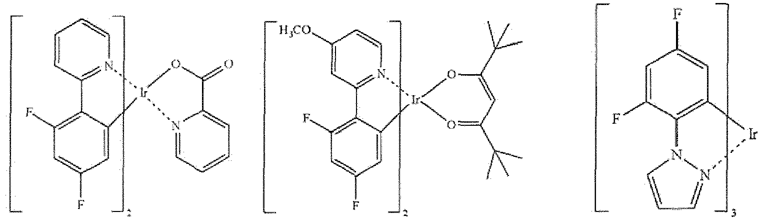

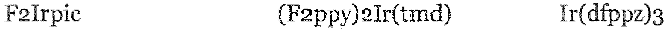

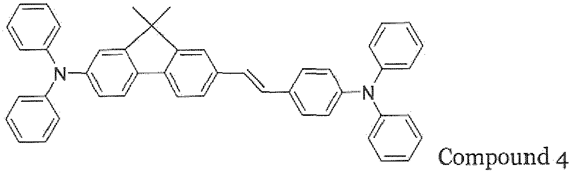

The amount of the emitter dopant may be in the range from about 0.01 to about 50 parts by weight, based on 100 parts by weight of the host. Alternatively, the emission layer may consist of a light-emitting polymer. The EML may have a thickness of about 10 nm to about 100 nm, for example, from about 20 nm to about 60 nm. When the thickness of the EML is within this range, the EML may have excellent light emission, without a substantial penalty in driving voltage.

### Hole blocking layer (HBL)

A hole blocking layer (HBL) may be formed on the EML, by using vacuum deposition, spin coating, slot-die coating, printing, casting, LB deposition, or the like, in order to prevent the diffusion of holes into the ETL. When the EML comprises a phosphorescent dopant, the HBL may have also a triplet exciton blocking function.

The HBL may also be named auxiliary ETL or a-ETL.

When the HBL is formed using vacuum deposition or spin coating, the conditions for deposition and coating may be similar to those for the formation of the HIL. However, the conditions for deposition and coating may vary, according to the compound that is used to form the HBL. Any compound that is commonly used to form a HBL may be used. Examples of compounds for forming the HBL include oxadiazole derivatives, triazole derivatives, and phenanthroline derivatives.

The HBL may have a thickness in the range from about 5 nm to about 100 nm, for example, from about 10 nm to about 30 nm. When the thickness of the HBL is within this range, the HBL may have excellent hole-blocking properties, without a substantial penalty in driving voltage.

### Electron transport layer (ETL)

The semiconducting device according to the present invention may comprise an electron transport layer (ETL).

By suitably adjusting the energy level of the ETL, the injection and transport of the electrons may be controlled, and the holes may be efficiently blocked. Thus, the OLED may have long lifetime.

The electron transport layer may comprise ETM materials comprising one or more electron transport compound(s) known in the art.

According to an embodiment, the electron transport layer comprises an electron transport compound, wherein the electron transport compound comprises 8 to 13 aromatic or heteroaromatic rings, optionally 8 to 11 aromatic or heteroaromatic rings, optionally 9 to 11 aromatic or heteroaromatic rings, and optionally 9 aromatic or heteroaromatic rings, wherein one or more of the aromatic or heteroaromatic rings may be substituted with C₁ to C₄ alkyl. In this regard, an aromatic, respectively heteroaromatic ring is a single aromatic ring, for example a 6-membered aromatic ring such as phenyl, a 6-membered heteroaromatic ring such as pyridyl, a 5-membered heteroaromatic ring such as pyrrolyl etc. In a system of condensed (hetero)aromatic rings, each ring is considered as a single ring in this regard. For example, naphthalene comprises two aromatic rings.

The electron transport compound may comprise at least one heteroaromatic ring, optionally 1 to 5 heteroaromatic rings, optionally 1 to 4 heteroaromatic rings, optionally 1 to 3 heteroaromatic rings, and optionally 1 or 2 heteroaromatic rings.

The aromatic or heteroaromatic rings of the electron transport compound may be 6-membered rings.

The heteroaromatic rings of the electron transport compound may be a N-containing heteroaromatic ring, optionally all of the heteroaromatic rings are N-containing heteroaromatic rings, optionally all of the heteroaromatic rings heteroaromatic rings contain N as the only type of heteroatom.

The electron transport compound may comprise at least one six-member heteroaromatic ring containing one to three N-atoms in each heteroaromatic ring, optionally one to three 6-membered heteroaromatic rings containing one to three N-atoms in each heteroaromatic ring, respectively.

The at least one 6-membered heteroaromatic ring comprised in the electron transport compound may be an azine. The at least one 6-membered heteroaromatic ring comprised in the electron transport compound may be triazine, diazine, pyrazine, pyrimidine, pyridine, quinazoline or bonzoquinazoline, preferably triazine.

If the electron transport compound comprises two or more heteroaromatic rings, the heteroaromatic rings may be separated from each other by at least one aromatic ring which is free of a heteroatom.

In an embodiment, the heteroatoms in the heteroaromatic rings of the electron transport compound are bound into the molecular structure of the electron transport compound by at least one double bond.

In one embodiment, the electron transport matrix compounds consist of covalently bound atoms. Preferably, the electron transport matrix compound comprises a conjugated system of at least 6, more preferably of at least 10 delocalized electrons. In one embodiment, the conjugated system of delocalized electrons may be comprised in aromatic or heteroaromatic structural moieties, as disclosed e.g. in documents EP 1 970 371 A1 or WO 2013/079217 A1.

Further, the electron transport layer may comprise one or more additives. The additive may be an n-type dopant. The additive can be alkali metal, alkali metal compound, alkaline earth metal, alkaline earth metal compound, transition metal, transition metal compound or a rare earth metal. In another embodiment, the metal can be one selected from a group consisting of Li, Na, K, Rb, Cs, Mg, Ca, Sr, Ba, La, Ce, Sm, Eu, Tb, Dy, and Yb. In another embodiment, the n-type dopant can be one selected from a group consisting of Cs, K, Rb, Mg, Na, Ca, Sr, Eu and Yb. In an embodiment the alkali metal compound may be 8-hydroxyquinolinolato-lithium (LiQ), lithium tetra(1H-pyrazol-1-yl)borate or lithium 2-(diphenylphosphoryl)phenolate. Suitable compounds for the ETM (which may be used in addition to the inventive compound as defined above) are not particularly limited. In one embodiment, the electron transport matrix compounds consist of covalently bound atoms. Preferably, the electron transport matrix compound comprises a conjugated system of at least 6, more preferably of at least 10 delocalized electrons. In one embodiment, the conjugated system of delocalized electrons may be comprised in aromatic or heteroaromatic structural moieties, as disclosed e.g. in documents EP 1 970 371 A1 or WO 2013/079217 A1.

### Electron injection layer (EIL)

The optional EIL, which may facilitate injection of electrons from the cathode, may be formed on the ETL, preferably directly on the electron transport layer. Examples of materials for forming the EIL include lithium 8-hydroxyquinolinolate (LiQ), LiF, NaCl, CsF, Li₂O, BaO, Ca, Ba, Yb, Mg, especially Yb which are known in the art. Deposition and coating conditions for forming the EIL are similar to those for formation of the HIL, although the deposition and coating conditions may vary, according to the material that is used to form the EIL.

The thickness of the EIL may be in the range from about 0.1 nm to about 10 nm, for example, in the range from about 0.5 nm to about 9 nm. When the thickness of the EIL is within this range, the EIL may have satisfactory electron-injecting properties, without a substantial penalty in driving voltage.

The electron injection layer may be in direct contact to the top-electrode.

### Cathode electrode

The top-electrode or the bottom electrode, preferably the top-electrode, may be a cathode. The cathode electrode may be formed on the EIL if present. The cathode electrode may be formed of a metal, an alloy, an electrically conductive compound, or a mixture thereof. The cathode electrode may have a low work function. For example, the cathode electrode may be formed of lithium (Li), magnesium (Mg), aluminum (Al), aluminum (Al)-lithium (Li), calcium (Ca), barium (Ba), ytterbium (Yb), magnesium (Mg)-indium (In), magnesium (Mg)-silver (Ag), or the like. Alternatively, the cathode electrode may be formed of a transparent conductive oxide, such as ITO or IZO. The cathode may comprise more than 50 volume % of metal selected from Ag and Au. The cathode may comprise more than 50 volume % of Ag.

The thickness of the cathode electrode may be in the range from about 5 nm to about 1000 nm, for example, in the range from about 10 nm to about 100 nm. When the thickness of the cathode electrode is in the range from about 5 nm to about 50 nm, the cathode electrode may be transparent or semitransparent even if formed from a metal or metal alloy.

The cathode may be a semi-transparent metal cathode having a thickness less than 20 nm, preferably less than 15 nm.

### Charge generation layer/hole generation layer

The charge generation layer (CGL) is composed of a double layer.

The charge generation layer is a pn junction joining an n-type charge generation layer (electron generation layer) and a p-type charge generation layer (hole generation layer). The n-side of the pn junction generates electrons and injects them into the layer which is adjacent in the direction to the anode. Analogously, the p-side of the p-n junction generates holes and injects them into the layer which is adjacent in the direction to the cathode.

Charge generation layers are used in tandem devices, for example, in tandem OLEDs comprising, between two electrodes, two or more emission layers. In a tandem OLED comprising two emission layers, the n-type charge generation layer provides electrons for the first light emission layer arranged near the anode, while the p-type charge generation layer provides holes to the second light emission layer arranged between the first emission layer and the cathode.

The hole generation layer (p-type charge generation layer) can be composed of an organic matrix material doped with p-type dopant. Suitable matrix materials for the hole generation layer may be materials conventionally used as hole injection and/or hole transport matrix materials. Also, p-type dopant used for the hole generation layer can employ conventional materials. For example, the p-type dopant can be one selected from a group consisting of tetrafluore-7,7,8,8-tetracyanoquinodimethane (F4-TCNQ), derivatives of tetracyanoquinodimethane, radialene derivatives, iodine, FeCl3, FeF3, and SbCl5. Also, the host can be one selected from a group consisting of N,N'-di(naphthalen-1-yl)-N,N-diphenyl-benzidine (NPB), N,N'-diphenyl-N,N'-bis(3-methylphenyl)-1,1-biphenyl-4,4'-diamine (TPD) and N,N',N'-tetranaphthyl-benzidine (TNB).

The n-type charge generation layer can be layer of a neat n-dopant, for example of an electropositive metal, or can consist of an organic matrix material doped with the n-dopant. In one embodiment, the n-type dopant can be alkali metal, alkali metal compound, alkaline earth metal, or alkaline earth metal compound. In another embodiment, the metal can be one selected from a group consisting of Li, Na, K, Rb, Cs, Mg, Ca, Sr, Ba, La, Ce, Sm, Eu, Tb, Dy, and Yb. More specifically, the n-type dopant can be one selected from a group consisting of Cs, K, Rb, Mg, Na, Ca, Sr, Eu and Yb. Suitable matrix materials for the electron generating layer may be the materials conventionally used as matrix materials for electron injection or electron transport layers. The matrix material can be for example one selected from a group consisting of triazine compounds, hydroxyquinoline derivatives like tris(8-hydroxyquinoline)aluminum, benzazole derivatives, and silole derivatives.

In one embodiment, the p-type charge generation layer may include compounds of the following Chemical Formula X. 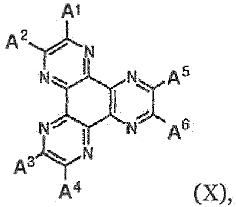 wherein each of A1 to A6 may be hydrogen, a halogen atom, nitrile (-CN), nitro (-NO₂), sulfonyl (-SO₂R), sulfoxide (-SOR), sulfonamide (-SO₂NR), sulfonate (-SO₃R), trifluoromethyl (-CF₃), ester (-COOR), amide (-CONHR or - CONRR'), substituted or unsubstituted straight-chain or branched-chain C₁-C₁₂ alkoxy, substituted or unsubstituted straight-chain or branched-chain C₁-C₁₂ alkyl, substituted or unsubstituted straight-chain or branched chain C₂-C₁₂ alkenyl, a substituted or unsubstituted aromatic or non-aromatic heteroring, substituted or unsubstituted aryl, substituted or unsubstituted mono- or di-arylamine, substituted or unsubstituted aralkylamine, or the like. Herein, each of the above R and R' may be substituted or unsubstituted C₁-C₆₀ alkyl, substituted or unsubstituted aryl, or a substituted or unsubstituted 5- to 7-membered heteroring, or the like.

An example of such p-type charge generation layer may be a layer comprising CNHAT

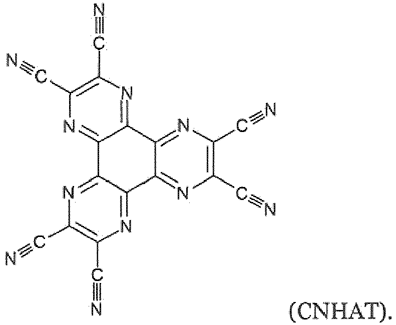

The hole generating layer may be arranged on top of the n-type charge generation layer.

With regard to the method for producing the organic light emitting diode, the alternative embodiments outlined above may be applied mutatis mutandis. For example, the charge generation layer may be produced with an interlayer provided between the n-type sub-layer, and the p-type sub-layer.

According to one aspect, the OLED according to the present invention can comprise a layer structure of a substrate that is adjacent arranged to an anode electrode, the anode electrode is adjacent arranged to a first hole injection layer, the first hole injection layer is adjacent arranged to a first hole transport layer, the first hole transport layer is adjacent arranged to a first electron blocking layer, the first electron blocking layer is adjacent arranged to a first emission layer, the first emission layer is adjacent arranged to a first electron transport layer, the first electron transport layer is adjacent arranged to an n-type charge generation layer (n-type sub-layer), the n-type charge generation layer is adjacent arranged to a hole generating layer (p-type sub-layer), an interlayer may be provided between the n-type sub-layer, and the p-type sub-layer, the hole generating layer is adjacent arranged to a second hole transport layer, the second hole transport layer is adjacent arranged to a second electron blocking layer, the second electron blocking layer is adjacent arranged to a second emission layer, between the second emission layer and the cathode electrode an optional electron transport layer and/or an optional injection layer are arranged.

### Display device

According to a further aspect, the invention is related to a display device comprising the organic light emitting device according to the invention. The display device may be a television, a tablet, or a mobile phone.

### Process for preparing the organic light emitting diode

According to a further aspect, the invention is related to a process for preparing the organic light emitting device according to the present invention, wherein the process comprises a step of depositing the optical outcoupling material to form the light scattering layer, especially depositing the optical outcoupling material on the top-electrode.

The method for depositing may comprise:
- deposition via vacuum thermal evaporation;
- deposition via solution processing, preferably the processing is selected from spin-coating, printing, casting; and/or
- slot-die coating.

### Compound of formula (II)

The present invention is further directed to a compound having the following formula (II)

G¹-L-G² (II).

In formula (II), G¹ is selected from (Ib) to (Id)

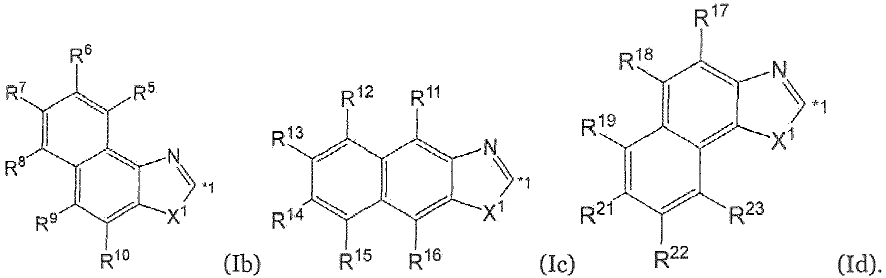

G¹ may be (Ib).

X¹ is O or S. X¹ may be O.

R⁵ to R²³ are independently selected from the group consisting of H, D and C₁ to C₈ alkyl. R⁵ to R²³ may be independently selected from the group consisting of H, D and C₁ to C₆ alkyl. R⁵ to R²³ may be independently selected from the group consisting of H, D and C₁ to C₄ alkyl. R⁵ to R²³ may be independently selected from the group consisting of H, D and C₁ to C₃ alkyl. R⁵ to R²³ may be independently selected from the group consisting of H, D and C₁ to C₂ alkyl. R⁵ to R²³ may be independently selected from the group consisting of H, D and methyl. R⁵ to R²³ may be independently selected from the group consisting of H and D.

G¹ is bonded at *1 to L. That is, for example, if G¹ is (Ia), the compound of formula (II) has the following structure

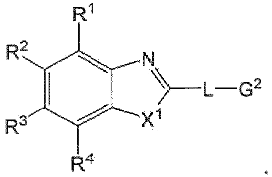

G² is selected from (Ib') to (Id')

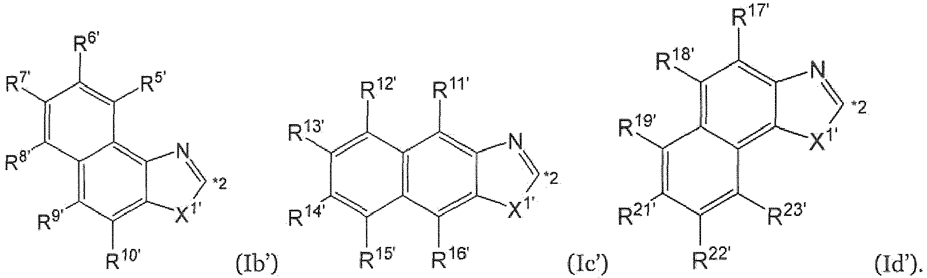

G² may be (Ib').

X¹' is O or S. X¹' may be O.

X¹ and X¹' may be both O.

R⁵' to R^{23'} are independently selected from the group consisting of H, D and C₁ to C₈ alkyl. R^{5'} to R^{23'} may be independently selected from the group consisting of H, D and C₁ to C₆ alkyl. R^{5'} to R^{23'} may be independently selected from the group consisting of H, D and C₁ to C₄ alkyl. R^{5'} to R^{23'} may be independently selected from the group consisting of H, D and C₃ to C₃ alkyl. R^{5'} to R^{23'} may be independently selected from the group consisting of H, D and C₁ to C₂ alkyl. R^{5'} to R^{23'} may be independently selected from the group consisting of H, D and methyl. R^{5'} to R^{23'} may be independently selected from the group consisting of H and D.

G² is bonded at *2 to L. That is, for example, if G² is (Ia'), the compound of formula (II) has the following structure

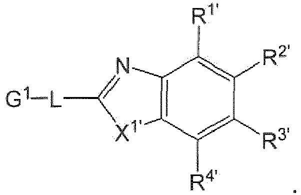

L has the formula (Ie) 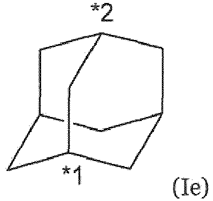 wherein (Ie) is bonded to G¹ at *1; and Ie is bonded to G² at *2. That is, the compound of formula (I) has the following structure

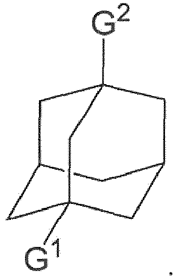

L may be substituted or unsubstituted.

In case that L is substituted, the one or more substituent(s) are independently selected from the group consisting of D, C₁ to C₈ alkyl, C₁ to Ca alkoxy, C_{3 to} C₉ silyl. In case that L is substituted, the one or more substituent(s) may be independently selected from the group consisting of D, C₁ to C₈ alkyl. In case that L is substituted, the one or more substituent(s) may be independently selected from the group consisting of D, C₁ to C₄ alkyl. In case that L is substituted, the one or more substituent(s) may be D.

G¹ and G² may be selected the same. In this regard, "selected the same" means that the same group/atom is used in the respective positions. For example, G¹ and G² are selected the same if R¹ is Ib and R^{1'} is Ib' wherein it may be preferred that both Ib and Ib' have the same substitution pattern (R⁵ = R^{5'}, R⁶ = R^{6'}, ...).

It may be provided that R⁵ and R^{5'} are selected the same; and R⁶ and R^{6'} are selected the same; and R⁷ and R^{7'} are selected the same; and R⁸ and R^{8'} are selected the same; and R⁹ and R^{9'} are selected the same; and R¹⁰ and R^{10'} are selected the same; and R¹¹ and R^{11'} are selected the same; and R¹² and R^{12'} are selected the same; and R¹³ and R^{13'} are selected the same; and R¹⁴ and R^{14'} are selected the same; and R¹⁵ and R^{15'} are selected the same; and R¹⁶ and R^{16'} are selected the same; and R¹⁷ and R^{17'} are selected the same; and R¹⁸ and R^{18'} are selected the same; and R¹⁹ and R^{19'} are selected the same; and R²⁰ and R^{20'} are selected the same; and R²¹ and R^{21'} are selected the same; and R²² and R^{22'} are selected the same; and R²³ and R^{23'} are selected the same. In this regard, "selected the same" means that the same group/atom is used in the respective positions. For example, R¹ and R^{1'} are selected the same if R¹ is methyl and R^{1'} is methyl.

It may be provided that G¹ and G² are selected the same; G¹ is Ib; and G² is Ib'.

It may be provided that
- G¹ and G² are selected the same;
- G¹ is lb; and G² is Ib';
- in Ib and Ib', R⁵ to R¹⁰ and R⁵ to R^{5'} are independently H or D.

The compound of the formula (II) may have the structure E2

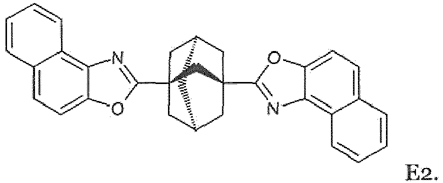

### Details and definitions of the invention

The term "comprise" or "include" when used in this specification, specifies the presence of stated elements, but does not preclude the presence or addition of one or more other elements, unless the context clearly indicates otherwise. However, unless explicitly stated otherwise, "comprising" or "including" or the like includes "essentially comprising" and "consisting of".

The term "essentially comprises" as used herein has the meaning of "comprising at least 70 %", preferably of "comprising at least 80 %", most preferred of "comprising at least 90 %". If reference is made to the amount of a constituent in a mixture of material, % is wt %, relative to the total weight of the respective mixture. For example, a light scattering layer essentially comprising the compound of formula (I) comprises the compound of formula (I) in an amount of at least 70 wt% with respect to the total weight of the light scattering layer.

An organic compound as referred to herein is generally any chemical compound that contains carbon (except some compounds generally referred to as being inorganic, such as carbonates, cyanides, carbon dioxide, diamond etc.). The term organic compound used herein also encompasses compounds such as organometallic compounds, for example metallocenes etc.

If not mentioned else explicitly, all compounds, groups, moieties, substituents etc. shown herein, especially by structural formulas, by systematic names etc. encompass the respective partially and fully deuterated derivatives thereof.

The term "zero-valent" as used herein refers to a metal in the oxidation state α, i.e. particular to metals from which no electron has been removed. The zero-valent metal may be present in the form of zero-valent atoms, neat metal, alloys etc.

The term "trivalent" as used herein refers to a nitrogen atom with a single bond and a double bond and containing a lone pair of electrons.

The term "hydrocarbyl group" as used herein shall be understood to encompass any organic group comprising carbon atoms, in particular organic groups, such as alkyl, aryl, heteroaryl, heteroalkyl, in particular such groups which are substituents usual in organic electronics.

The term "conjugated system" as used herein refer to a system of alternating π- and σ-bonds or a molecule having alternating single and multiple bonds i.e. double bond or a system having one or more two-atom structural units having the π-bond between its atoms can be replaced by an atom bearing at least one lone electron pair, typically by a divalent O or S atom.

The term "alkyl" as used herein shall encompass linear as well as branched and cyclic alkyl. For example, C₃-alkyl may be selected from n-propyl and iso-propyl. Likewise, C₄-alkyl encompasses n-butyl, sec-butyl and t-butyl. Likewise, C₆-alkyl encompasses n-hexyl and cyclohexyl.

The subscribed number n in Cn relates to the total number of carbon atoms in the respective alkyl, arylene, heteroarylene or aryl group.

The term "aryl" or "arylene" as used herein shall encompass phenyl (C₆-aryl), fused aromatics, such as naphthalene, anthracene, phenanthrene, tetracene etc.. Further encompassed are biphenyl and oligo- or polyphenyls, such as terphenyl, phenyl-substituted biphenyl, phenyl-substituted terphenyl (such as tetraphenyl benzole groups) etc.. "Arylene" respectively "heteroarylene", refers to groups to which two further moieties are attached. In the present specification, the term "aryl group" or "arylene group" may refer to a group comprising at least one hydrocarbon aromatic moiety, and all the elements of the hydrocarbon aromatic moiety may have p-orbitals which form conjugation, for example a phenyl group, a napthyl group, an anthracenyl group, a phenanthrenyl group, a pyrinyl group, a fluorenyl group and the like. Further encompoassed are spiro compounds in which two aromatic moieties are connected with each other via a spiro-atom, such as 9,9'-spirobi[9H-fluorene]yl. The aryl or arylene group may include a monocyclic or fused ring polycyclic (i.e., links sharing adjacent pairs of carbon atoms) functional group.

The term "heteroaryl" as used herein refers to aryl groups in which at least one carbon atom is substituted with a heteroatom. The term "heteroaryl" may refer to aromatic heterocycles with at least one heteroatom, and all the elements of the hydrocarbon heteroaromatic moiety may have p-orbitals which form conjugation. The heteroatom may be selected from N, O, S, B, Si, P, Se, preferably from N, O and S. A heteroarylene ring may comprise at least 1 to 3 heteroatoms. Preferably, a heteroarylene ring may comprise at least 1 to 3 heteroatoms individually selected from N, S and/or O. Just as in case of "aryl"/"arylene", the term "heteroaryl" comprises, for example, spiro compounds in which two aromatic moieties are connected with each other, such as spiro[fluorene-9,9'-xanthene]. Further exemplary heteroaryl groups are diazine, triazine, dibenzofurane, dibenzothiofurane, acridine, benzoacridine, dibenzoacridine etc.

The subscripted number n in Cₙ-heteroaryl merely refers to the number of carbon atoms excluding the number of heteroatoms. In this context, it is clear that a C₃ heteroarylene group is an aromatic compound comprising three carbon atoms, such as pyrazol, imidazole, oxazole, thiazole and the like.

The term "halogenated" refers to an organic compound in which one hydrogen atom thereof is replaced by a halogen atom. The term "perhalogenated" refers to an organic compound in which all of the hydrogen atoms thereof are replaced by halogen atoms. The meaning of the terms "fluorinated" and "perfluorinated" should be understood analogously.

The term "alkenyl" as used herein refers to a group -CR¹ = CR²R³ comprising a carbon-carbon double bond.

The term "perhalogenated" as used herein refers to a hydrocarbyl group wherein all of the hydrogen atoms of the hydrocarbyl group are replaced by halogen (F, Cl, Br, I) atoms.

The term "alkoxy" as used herein refers to a structural fragment of the Formula -OR with R being hydrocarbyl, preferably alkyl or cycloalkyl.

The term "thioalkyl" as used herein refers to a structural fragment of the Formula -SR with R being hydrocarbyl, preferably alkyl or cycloalkyl.

In the present specification, the term single bond refers to a direct bond.

In terms of the invention, a group is "substituted with" another group if one of the hydrogen atoms comprised in this group is replaced by another group, wherein the other group is the substituent.

In terms of the invention, the expression "between" with respect to one layer being between two other layers does not exclude the presence of further layers which may be arranged between the one layer and one of the two other layers. In terms of the invention, the expression "in direct contact" with respect to two layers being in direct contact with each other means that no further layer is arranged between those two layers. One layer deposited on the top of another layer is deemed to be in direct contact with this layer.

In the context of the present specification the term "essentially non-emissive" or "non-emissive" means that the contribution of the compound or layer to the visible emission spectrum from the device is less than 10 %, preferably less than 5 % relative to the visible emission spectrum. The visible emission spectrum is an emission spectrum with a wavelength of about ≥ 380 nm to about ≤ 780 nm.

With respect to the inventive organic light emitting device, the compounds mentioned in the experimental part may be most preferred.

The organic electroluminescent device (OLED) may be a bottom- or top-emission device.

Another aspect is directed to a device comprising at least one organic electroluminescent device (OLED). A device comprising organic light-emitting diodes is for example a display or a lighting panel.

In the present invention, the following defined terms, these definitions shall be applied, unless a different definition is given in the claims or elsewhere in this specification.

In the context of the present specification the term "different" or "differs" in connection with the matrix material means that the matrix material differs in their structural formula.

The energy levels of the highest occupied molecular orbital, also named HOMO, and of the lowest unoccupied molecular orbital, also named LUMO, are measured in electron volt (eV).

The terms "OLED" and "organic light-emitting diode" are simultaneously used and have the same meaning. The term "organic electroluminescent device" as used herein may comprise both organic light emitting diodes as well as organic light emitting transistors (OLETs).

As used herein, "weight percent", "wt.-%", wt%, "percent by weight", "% by weight", and variations thereof refer to a composition, component, substance or agent as the weight of that component, substance or agent of the respective electron transport layer divided by the total weight of the respective electron transport layer thereof and multiplied by 100. It is understood that the total weight percent amount of all components, substances and agents of the respective electron transport layer and electron injection layer are selected such that it does not exceed 100 wt.-%.

As used herein, "volume percent", "vol.-%", "percent by volume", "% by volume", and variations thereof refer to a composition, component, substance or agent as the volume of that component, substance or agent of the respective electron transport layer divided by the total volume of the respective electron transport layer thereof and multiplied by 100. It is understood that the total volume percent amount of all components, substances and agents of the cathode layer are selected such that it does not exceed 100 vol.-%.

All numeric values are herein assumed to be modified by the term "about", whether or not explicitly indicated. As used herein, the term "about" refers to variation in the numerical quantity that can occur. Whether or not modified by the term "about" the claims include equivalents to the quantities.

It should be noted that, as used in this specification and the appended claims, the singular forms "a", "an", and "the" include plural referents unless the content clearly dictates otherwise.

The term "free of", "does not contain", "does not comprise" does not exclude impurities. Impurities have no technical effect with respect to the object achieved by the present invention. The term "free of" a compound means that such compound/material is not deliberately added to the layer during processing.

Preferably, the semiconducting layer according to the invention and layers in an OLED formed thereof are essentially non-emissive or non-emitting.

The operating voltage, also named U, is measured in Volt (V) at 10 milliampere per square centimeter (mA/cm²).

The candela per Ampere efficiency, also named cd/A efficiency is measured in candela per ampere at 10 milliAmpere per square centimeter (mA/cm2).

The external quantum efficiency, also named EQE, is measured in percent (%).

The color space is described by coordinates CIE-x and CIE-y (International Commission on Illumination 1931). For blue emission the CIE-y is of particular importance. A smaller CIE-y denotes a deeper blue color. Efficiency values are compared at the same CIE-y.

The highest occupied molecular orbital, also named HOMO, and lowest unoccupied molecular orbital, also named LUMO, are measured in electron volt (eV).

The term "OLED", "organic light emitting diode", "organic light emitting device", "organic optoelectronic device" and "organic light-emitting diode" are simultaneously used and have the same meaning.

The term "life-span" and "lifetime" are simultaneously used and have the same meaning.

The anode and cathode may be described as anode electrode / cathode electrode or anode electrode / cathode electrode or anode electrode layer / cathode electrode layer.

Room temperature, also named ambient temperature, is 23° C.

Hereinafter, the embodiments are illustrated in more detail with reference to examples. However, the present disclosure is not limited to the following examples. Reference will now be made in detail to the exemplary aspects.

### DESCRIPTION OF THE DRAWINGS

The aforementioned components, as well as the claimed components and the components to be used in accordance with the invention in the described embodiments, are not subject to any special exceptions with respect to their size, shape, material selection and technical concept such that the selection criteria known in the pertinent field can be applied without limitations.

Additional details, characteristics and advantages of the object of the invention are disclosed in the dependent claims and the following description of the respective figures which in an exemplary fashion show preferred embodiments according to the invention. Any embodiment does not necessarily represent the full scope of the invention, however, and reference is made therefore to the claims and herein for interpreting the scope of the invention. It is to be understood that both the foregoing general description and the following detailed description are exemplary and explanatory only and are intended to provide further explanation of the present invention as claimed.

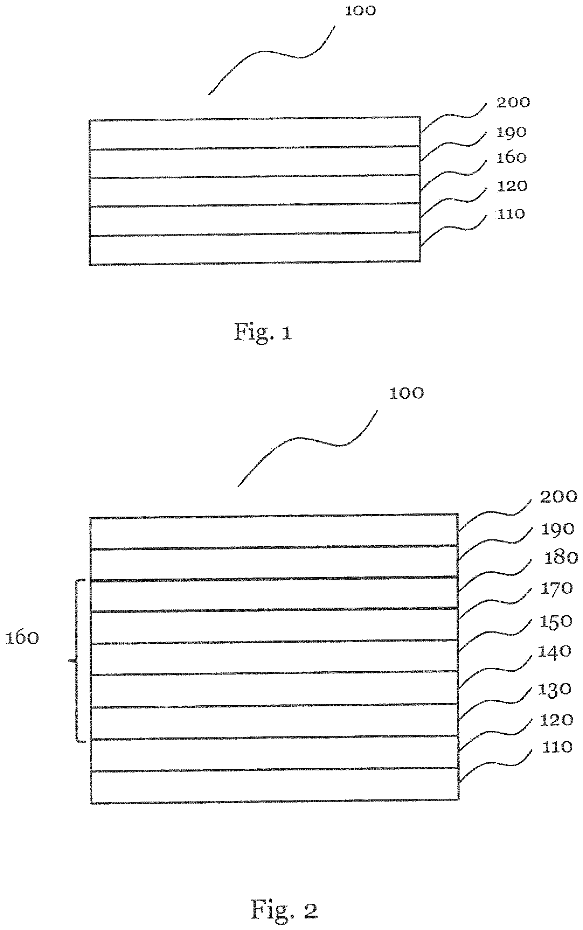

FIG. 1 is a schematic sectional view of an organic light emitting device (OLED), according to the present invention;
FIG. 2 is a schematic sectional view of an OLED, according to an exemplary embodiment of the present invention.

### EXPERIMENTAL PART

### Synthesis procedures

### 1,3-bis(naphtho[1,2-d]oxazol-2-yl)adamantine (E2)

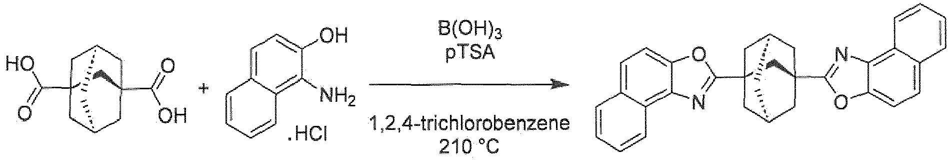

1,3-adamantanedicarboxylic acid (12.9 g, 57 mmol), 1-amino-2-naphthol hydrochloride (24.7 g, 126 mmol), boric acid (1.78 g, 28.7 mmol) and p-toluenesulfonic acid monohydrate (5.46 g, 28.7 mmol), were suspended in 1,2,4-trichlorobenzene (200 mL) in a flask equipped with a Dean-Stark apparatus. The mixture was heated to 150 °C for 30 min, then to 210 °C for 16 h. After cooling to RT, 500 mL of methanol was added. As no precipitate formed, all volatiles were removed by distillation under reduced pressure. The residue was macerated with methanol and a methanol/water mixture, and subsequently purified by flash column chromatography to yield the pure product (5.4 g, 20%).
HPLC purity: 99.6%
ESI-APCI-MS: m/z = 471 ([MH]⁺)

### Supporting materials for device experiments

ITO is indium tin oxide.

G1 is

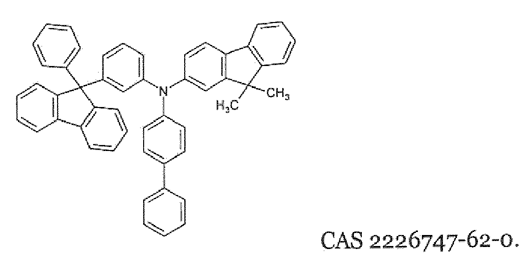

PD2 is

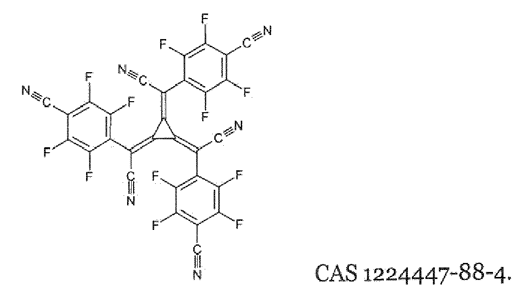

GH1 is a green host consisting of two components having formulae

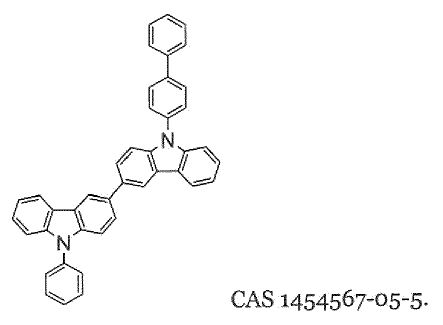

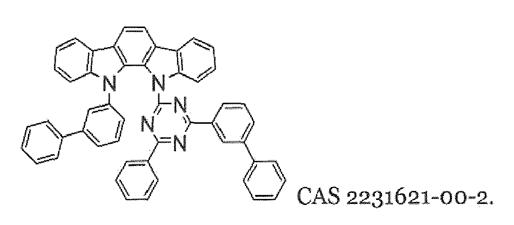

GD1 is a green emitter dopant having formula

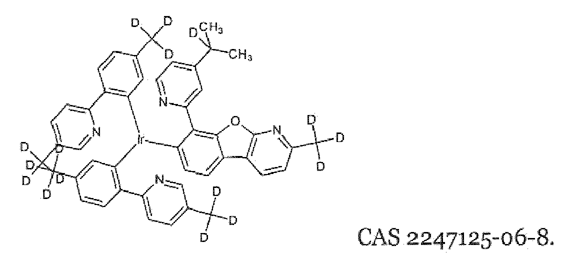

G2 is

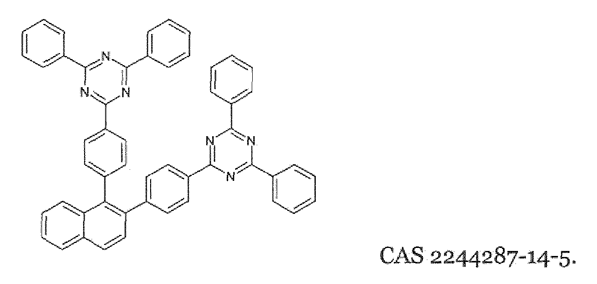

LiQ is lithium 8-hydroxyquinolinolate, CAS 850918-68-2.

### Device experiments

Organic light emitting diodes schematically described in Table 1 have been prepared.

**Table 1:**

| Layer | Material | Concentration (vol. %) | d [nm] |
|---|---|---|---|
| CPL | Tested compound: E1, E2 or G3 | 100 | 75 |
| Cathode | Ag:Mg | 90:10 | 13 |
| EIL | Yb | 100 | 2 |
| ETL | G2:LiQ | 50:50 | 58 |
| EML | GH1:GD1 | 90:10 | 25 |
| HTL | G1 | 100 | 165 |
| HIL | G1:PD2 | 93:7 | 5 |
| Anode | ITO/Ag/ITO | 100/100/100 | 10/120/10 |

### Compounds in accordance with the invention

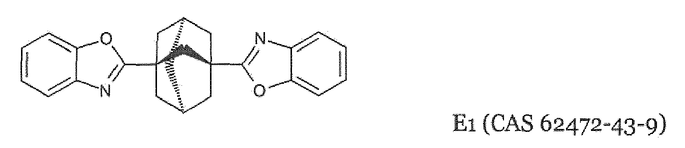

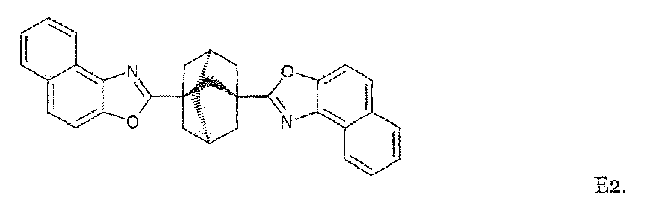

### Comparative compound

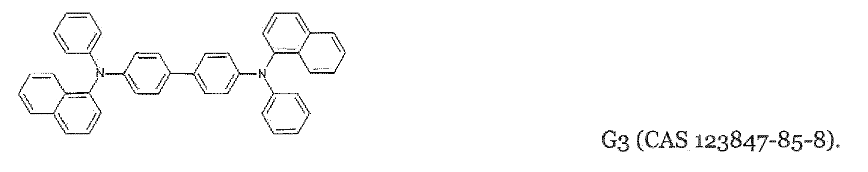

### Measurement of quantum efficiency

The external quantum efficiency (EQE) of the devices in accordance with Table 1 was measured in an integrating sphere at 10 mA/cm². The integrating sphere (ISP 500-100) and spectrometer (CAS 140 CT) are both from Instrument Systems.

The results are summarized in Table 2

**Table 2:**

| **CPL** | **nm** | **Rel. EQE (%)** |
|---|---|---|
| G3 | 75 | 100 |
| E1 | 75 | 107-110 |
| E2 | 75 | 125 |

In comparison with state-of-art CPL material G3, the inventive CPL materials E1 and E2 enable higher quantum efficiency of the tested devices.

The features disclosed in the foregoing description and in the dependent claims may, both separately and in any combination thereof, be material for realizing the aspects of the disclosure made in the independent claims, in diverse forms thereof.

## Claims

1. An optical outcoupling material comprising a compound of the formula (I)
G¹-L-G² (I)
wherein
- G¹ is selected from (Ia) to (Id) 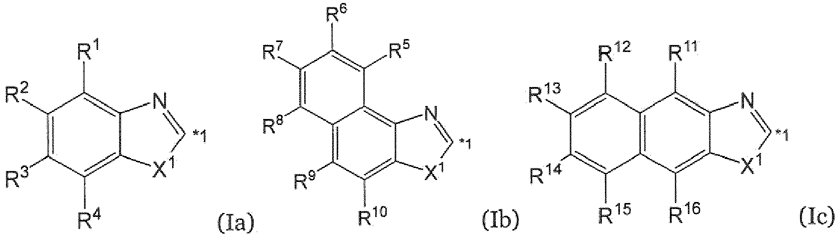 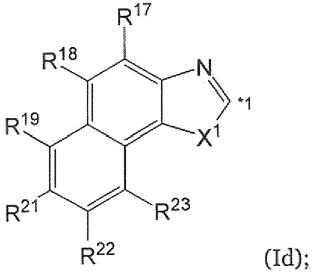
- X¹ is O or S;
- R¹ to R²³ are independently selected from the group consisting of H, D and C₁ to C₈ alkyl;
- G¹ is bonded at *1 to L;
- G² is selected from (Ia') to (Id') 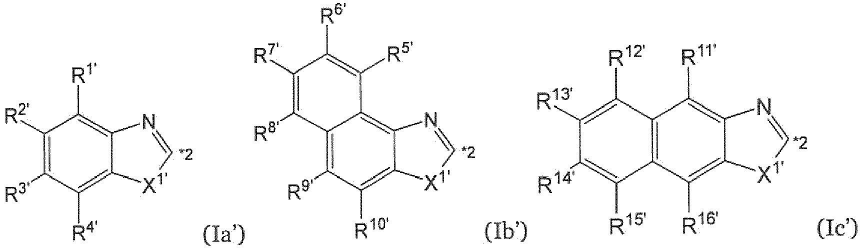 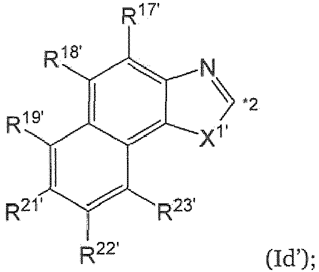
- X^{1'} is O or S;
- R^{1'} to R^{23'} are independently selected from the group consisting of H, D and C₁ to C₈ alkyl;
- G² is bonded at *2 to L;
- L is selected from the group consisting of substituted or unsubstituted C₁ to C₃₀ hydrocarbyl comprising at least two sp³-carbon atoms; and substituted or unsubstituted C₁ to C₃₀ heterohydrocarbyl comprising at least two sp³-carbon atoms;
- L is bonded to G¹ and G² via different sp³-carbon atoms, respectively; and
- in case that L is substituted, the one or more substituent(s) are independently selected from the group consisting of D, C₁ to C₈ alkyl, C₁ to C₈ alkoxy, C_{3 to} C₉ silyl.

2. The optical outcoupling material according to claim 1, wherein X¹ and X^{1'} are O.

3. The optical outcoupling material according to claim 1 or 2, wherein R¹ to R²³ and R¹ to R²³ are independently selected from the group consisting of H, D and C₁ to C₄ alkyl.

4. The optical outcoupling material according to any of the preceding claims, wherein G¹ is selected from Ia and Ib; and G² is selected from Ia' and Ib'.

5. The optical outcoupling material according to any of the preceding claims, wherein L is C₆ to C₁₅ alkylene.

6. The optical outcoupling material according to any of the preceding claims, wherein L is C₆ to C₁₅ polycyclic alkylene.

7. The optical outcoupling material according to any of the preceding claims, wherein L has the formula (Ie) 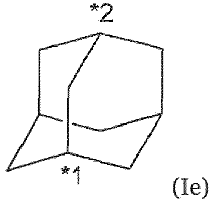 wherein Ie is bonded to G¹ at *1; and Ie is bonded to G² at *2.

8. The optical outcoupling material according to any of the preceding claims, wherein R¹ and R^{1'} are selected the same; and R² and R^{2'} are selected the same; and R³ and R^{3'} are selected the same; and R⁴ and R^{4'} are selected the same; and R⁵ and R^{5'} are selected the same; and R⁶ and R^{6'} are selected the same; and R⁷ and R^{7'} are selected the same; and R⁸ and R^{8'} are selected the same; and R9 and R9' are selected the same; and R¹⁰ and R^{10'} are selected the same; and R¹¹ and R^{11'} are selected the same; and R¹² and R^{12'} are selected the same; and R¹³ and R^{13'} are selected the same; and R¹⁴ and R^{14'} are selected the same; and R¹³ and R^{15'} are selected the same; and R¹⁶ and R^{16'} are selected the same; and R¹⁷ and R^{17'} are selected the same; and R¹⁸ and R^{18'} are selected the same; and R¹⁹ and R^{19'} are selected the same; and R²⁰ and R^{20'} are selected the same; and R²¹ and R^{21'} are selected the same; and R²² and R^{22'} are selected the same; and R²³ and R^{23'} are selected the same.

9. The optical outcoupling material according to any of the preceding claims, wherein
- G¹ is selected from Ia and Ib; and G² is selected from Ia' and Ib';
- in Ia and Ia', R² and R^{2'} are independently selected from C₁ to C₄ alkyl; and
- in Ia and Ia', R¹, R³ and R⁴, and R^{1'}, R^{3'} R^{4'} are independently H or D.

10. An organic light emitting device comprising a light scattering layer comprising the optical outcoupling material according to any of the preceding claims.

11. The organic light emitting device according to claim 10 comprising a substrate, a bottom-electrode, a top-electrode, an electronically active region and the light-scattering layer,
wherein
- the electronically active region is arranged between and in direct contact with the bottom-electrode and the top-electrode;
- the bottom electrode is closer to the substrate than the top-electrode; and
- the light-scattering layer is arranged outside the electronically active region and is arranged on the top-electrode.

12. The organic light emitting device according to claim 10 or 11, wherein the light scattering layer is in direct contact with the top-electrode.

13. The organic light emitting device according to any of the claims 10 to 12, wherein the top-electrode comprises silver.

14. A display device comprising the organic light emitting device according to any of the claims 10 to 13.

15. Compound of the formula (II)
G¹-L-G² (II)
wherein
- G¹ is selected from (Ib) to (Id) 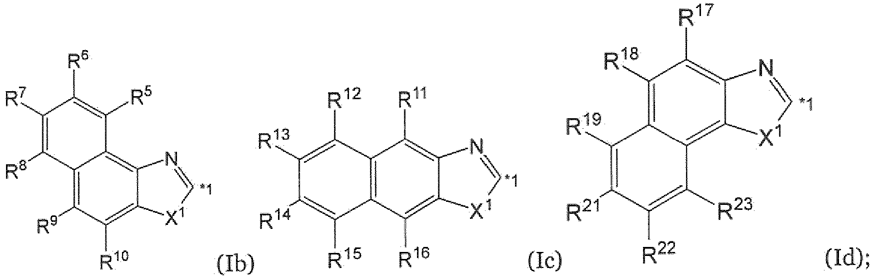
- X¹ is O or S;
- R⁵ to R²³ are independently selected from the group consisting of H, D and C₁ to C₈ alkyl;
- G¹ is bonded at *1 to L;
- G² is selected from (Ib') to (Id') 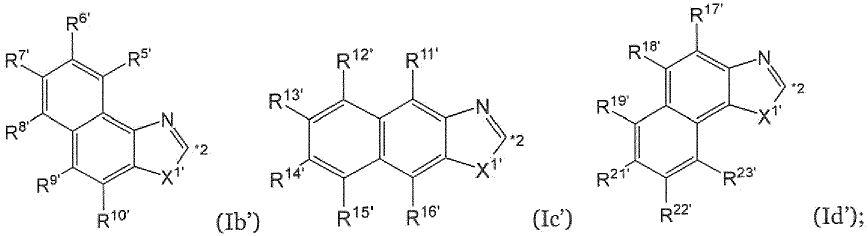
- X¹' is O or S;
- R^{5'} to R^{23'} are independently selected from the group consisting of H, D and C₁ to C₈ alkyl;
- G² is bonded at *2 to L;
- L has the formula (Ie) 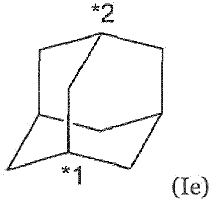 wherein Ie is bonded to G¹ at *1; and Ie is bonded to G² at *2;
- L may be substituted or unsubstituted; and
- in case that L is substituted, the one or more substituent(s) are independently selected from the group consisting of D, C₁ to C₈ alkyl, C₁ to C₈ alkoxy, C_{3 to} C₉ silyl.
